# EUROPEAN PATENT APPLICATION

(11) **EP 4 742 864 A1**
(43) Date of publication of application: **13.05.2026**
(21) Application number: 25191385.1
(22) Date of filing: 23.07.2025
(51) Int. Cl.: H10H 20/814, H10H 20/816, H10H 20/824, H10H 20/831, H10H 20/832

(54) **FLIP CHIP LIGHT EMITTING DIODE**

(30) Priority: 12.11.2024 TW 113143310
(71) Applicant: Taiwan-Asia Semiconductor Corporation, Hsinchu City 30078 (TW)
(72) Inventor: Lin, Kun-Li, 30078 Hsinchu City (TW); Hsiao, Yu-Tong, 30078 Hsinchu City (TW); Chen, Huang-Ming, 30078 Hsinchu City (TW)
(74) Representative: Michalski Hüttermann & Partner Patentanwälte mbB

(57) **Abstract**

The present invention provides a flip-chip light-emitting diode, comprising a substrate, a light-emitting structure, a P-type electrode structure, and an N-type electrode structure. The light-emitting structure is disposed on the substrate and includes a gallium phosphide layer and a semiconductor epitaxy structure, with the gallium phosphide layer positioned between the substrate and the semiconductor epitaxy structure. The semiconductor epitaxy structure has, in sequence, a P-type current diffusing layer, a light-emitting layer, an N-type semiconductor layer, and a transparent ohmic contact layer. The P-type electrode structure is disposed on the gallium phosphide layer of the light-emitting structure, and the N-type electrode structure is disposed on the transparent ohmic contact layer. The N-type semiconductor layer has a distributed Bragg reflector, which is positioned between the light-emitting layer and the N-type electrode structure.

## Description

### CROSS REFERENCE TO RELATED APPLICATION

This application claims the benefit of Taiwan Patent Application Serial No. 113143310 filed on November 12, 2024. The entirety of the Application is incorporated herein by reference.

### BACKGROUND OF THE INVENTION

### 1. Field of the Invention

The present invention relates to a light-emitting diode, and more particularly, to a flip-chip light-emitting diode with decreased shadow regions generated by electrodes.

### 2. Description of Related Art

For conventional light-emitting diodes, in structural design, electrodes are disposed above light-emitting regions. As a result, under near-field optics, shadow regions occur corresponding to positions of the electrodes, which in turn affects light-emitting performances of the light-emitting diodes. While conventional flip-chip light-emitting diodes adopt different structural designs from the conventional light-emitting diodes, by disposing electrodes below the light-emitting regions, instead of above the light-emitting regions, to avoid forming the aforementioned shadow regions. However, for the conventional flip-chip light-emitting diodes, due to differences in materials used for the electrodes and other structural components, variations in reflectivity appear, which will still induce other shadow regions under near-field optics, even though the electrodes are disposed below the light-emitting regions, and similarly affects light-emitting performances of the flip-chip light-emitting diodes. Furthermore, if current distributing of the flip-chip light-emitting diodes is uneven, the shadow regions formed by the electrodes will become more obvious.

In light of this, it is really worthy of research and development to design a flip-chip light-emitting diode for solving those above-mentioned problems.

### SUMMARY OF THE INVENTION

An objective of the present invention is to provide a flip-chip light-emitting diode with decreased shadow regions generated by electrodes.

To achieve the above objective, the flip-chip light-emitting diode of the present invention comprises a substrate, a light-emitting structure, a P-type electrode structure, and an N-type electrode structure. The light-emitting structure is disposed on the substrate and includes a gallium phosphide layer and a semiconductor epitaxy structure, wherein the gallium phosphide layer is positioned between the substrate and the semiconductor epitaxy structure. The semiconductor epitaxy structure has a P-type current diffusing layer, a light-emitting layer, an N-type semiconductor layer, and a transparent ohmic contact layer, wherein the P-type current diffusing layer is disposed on the gallium phosphide layer, the light-emitting layer is disposed on the P-type current diffusing layer, the N-type semiconductor layer is disposed on the light-emitting layer, and the transparent ohmic contact layer is disposed on the N-type semiconductor layer. The P-type electrode structure is disposed on the gallium phosphide layer of the light-emitting structure, and the N-type electrode structure is disposed on the transparent ohmic contact layer. The N-type semiconductor layer has a distributed Bragg reflector, and the distributed Bragg reflector is located between the light-emitting layer and the N-type electrode structure.

In one embodiment of the present invention, the N-type electrode structure includes a current confinement layer and a metal reflection layer. The current confinement layer is disposed on the transparent ohmic contact layer and has a plurality of openings, and the metal reflection layer covers the current confinement layer to form an omni-directional reflector in conjunction with the current confinement layer. And the metal reflection layer forms a plurality of dot ohmic contact structures with the transparent ohmic contact layer through the plurality of openings.

In one embodiment of the present invention, the current confinement layer is made of a non-conductive material.

In one embodiment of the present invention, a resistance of the P-type current diffusing layer is lower than a resistance of the N-type semiconductor layer.

In one embodiment of the present invention, the P-type current diffusing layer is an aluminum gallium arsenide layer with a doping concentration exceeding 1E+19 atoms/cm³.

In one embodiment of the present invention, the transparent ohmic contact layer is made of a material that does not absorb light emitted by the light-emitting layer within a corresponding emission wavelength band thereof.

In one embodiment of the present invention, the P-type electrode structure includes a finger electrode portion and a pad portion. The finger electrode portion respectively contacts with the gallium phosphide layer of the light-emitting structure and with the pad portion, and the finger electrode portion is positioned in a periphery of the semiconductor epitaxy structure and symmetrically arranged with respect to a center of the semiconductor epitaxy structure.

In one embodiment of the present invention, the P-type electrode structure is disposed on a periphery of the semiconductor epitaxy structure and is symmetrically arranged around the center of the semiconductor epitaxy structure.

In one embodiment of the present invention, the finger electrode portion is a frame electrode, and the N-type electrode structure is either a plurality of regularly arranged dot electrodes or another frame electrode.

In one embodiment of the present invention, the finger electrode portion is a set of parallel line electrodes, and the N-type electrode structure is either a plurality of regularly arranged dot electrodes or another set of parallel line electrodes that are parallel to the finger electrode portion.

In one embodiment of the present invention, the N-type electrode structure is a plurality of dot ohmic contact structures disposed on the transparent ohmic contact layer, and each of the dot ohmic contact structures forms an ohmic contact with the transparent ohmic contact layer.

### BRIEF DESCRIPTION OF THE DRAWINGS

FIG. 1 is a top view of a flip-chip light-emitting diode of the present invention.
FIG. 2 is a schematic cross-sectional view along a segment A-A in FIG. 1 of the flip-chip light-emitting diode of the present invention.
FIG. 3 is an exemplary layout view of a finger electrode portion of a P-type electrode structure and at least one ohmic contact structure of a N-type electrode structure of the flip-chip light-emitting diode of the present invention.
FIG. 4 is another exemplary layout view of the finger electrode portion of the P-type electrode structure and the at least one ohmic contact structure of the N-type electrode structure of the flip-chip light-emitting diode of the present invention.
FIG. 5 is a schematic view of another embodiment of the flip-chip light-emitting diode of the present invention.

### DETAILED DESCRIPTION OF THE PREFERRED EMBODIMENT

Since various examples and embodiments in the present invention are only illustrative and non-restrictive, a person skilled in the art can easily conceive other examples and embodiments without contravening the scope of the present invention, after reading this specification, and can make the features and advantages of these embodiments more evident based on the following detailed description and claims.

Herein, the description of unit, element and component in the present invention uses "one", "a", or "an". This is for convenience and for offering general meaning of the category of the present invention. Therefore, the description should be understood as including "one", "at least one", and singular and plural forms at the same time unless the context clearly indicates otherwise.

Herein, the description of the terms "first" or "second" and similar ordinal numbers are mainly used to distinguish or refer to the same or similar elements or structures and do not necessarily imply that such components or structures are spatially or temporally distinct order. It should be understood that ordinal numbers, in certain situations or configurations, may be used interchangeably without affecting the implementation of the present invention.

Herein, the description of "comprise", "have" or other similar semantics have the non-exclusive meaning. For example, components or structures with a plurality of elements are not only limited to those disclosed in this specification, but also include generally inherent elements, which are not explicitly listed here for the components or the structures.

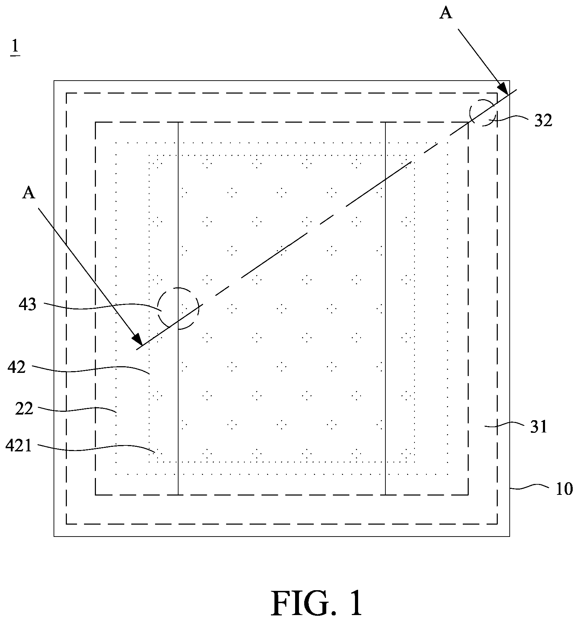

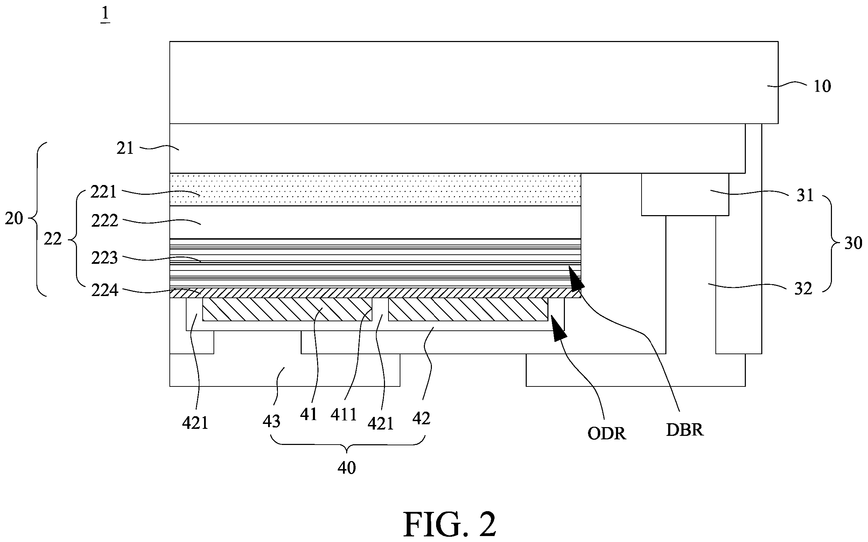

Please refer to FIG. 1 and FIG. 2 together. Wherein FIG. 1 is a top view of a flip-chip light-emitting diode of the present invention, and FIG. 2 is a schematic cross-sectional view along a segment A-A in FIG. 1 of the flip-chip light-emitting diode of the present invention. As shown in FIG. 1 and FIG. 2, a flip-chip light-emitting diode 1 of the present invention mainly comprises a substrate 10, a light-emitting structure 20, a P-type electrode structure 30, and an N-type electrode structure 40. The substrate 10 serves as a basic structure component of the flip-chip light-emitting diode 1, and is utilized to carry the light-emitting structure 20, the P-type electrode structure 30, the N-type electrode structure 40 and other related components. In this invention, the substrate 10 is made of sapphire material, but the substrate 10 can also be made of other common substrate materials.

The light-emitting structure 20 is disposed on the substrate 10 and is configured to emit light within an emission wavelength band correspondingly after being electrically conducted, based on selected structure materials. The light-emitting structure 20 includes a gallium phosphide (GaP) layer 21 and a semiconductor epitaxy structure 22, and the gallium phosphide layer 21 is positioned between the substrate 10 and the semiconductor epitaxy structure 22. Specifically, one surface of the gallium phosphide layer 21 is in contact with the substrate 10, while an opposite surface is in contact with the semiconductor epitaxy structure 22, such that the semiconductor epitaxy structure 22 is protruded on the gallium phosphide layer 21. The gallium phosphide layer 21 is provided for forming of subsequent flip-chip structures and for offering current diffusing effects. The semiconductor epitaxy structure 22 has, in sequence, a P-type current diffusing layer 221, a light-emitting layer 222, an N-type semiconductor layer 223, and a transparent ohmic contact layer 224. The P-type current diffusing layer 221 is disposed on the gallium phosphide layer 21, the light-emitting layer 222 is disposed on the P-type current diffusing layer 221, the N-type semiconductor layer 223 is disposed on the light-emitting layer 222, and the transparent ohmic contact layer 224 is disposed on the N-type semiconductor layer 223.

In one embodiment of the present invention, the P-type current diffusing layer 221 is made of P-type aluminum gallium arsenide (P-AlGaAs) material, with a thickness of approximately 2 µm. The chemical formula of P-type aluminum gallium arsenide is AlxGa_{1-X}As, where 0 < X < 1. To enhance a current diffusing effect of the P-type current diffusing layer 221, the P-type current diffusing layer 221 is given as a heavily doped semiconductor material layer. For example, in one embodiment of the present invention, a doping concentration of the P-type current diffusing layer 221 exceeds 1E+19 atoms/cm³, but the present invention is not limited to this. Additionally, in terms of design, a resistance of the P-type current diffusing layer 221 is lower than that of the N-type semiconductor layer 223, which makes electric currents flow toward the P-type current diffusing layer 221 more easily, thereby providing current diffusing effects through the P-type current diffusing layer 221. The light-emitting layer 222 is a multiple quantum well (MQW) layer used to emit light.

The N-type semiconductor layer 223 is made of N-type semiconductor material. In the present invention, the N-type semiconductor layer 223 has a distributed Bragg reflector (DBR) which is formed directly from N-type semiconductor material. The distributed Bragg reflector (DBR) is located between the light-emitting layer 222 and the N-type electrode structure 40, acting as a mirror primarily used to reflect light emitted from the light-emitting layer 222 toward the N-type semiconductor layer 223. In terms of design, the distributed Bragg reflector (DBR) can be formed, according to required reflectivities (for example, prospectively reaching for reflectivities between about 90% to 99%), by stacking of several or tens of layers of N-type semiconductor material. In one embodiment of the present invention, the N-type semiconductor material is made of N-type aluminum gallium arsenide (AlxGa_{1-X}As, where 0 < X < 1), and the distributed Bragg reflector (DBR) is formed by (λ/4)n heterojunctions under conditions with small lattice constant differences. For example, a distributed Bragg reflector (DBR) corresponding to a wavelength of 940 nm is formed by alternating layers of Al_{0.1}Ga_{0.9}As and AlAs. However, the present invention is not limited thereto.

In one embodiment of the present invention, the transparent ohmic contact layer 224 is made of a material that does not absorb the light, emitted from the light-emitting layer 222, within the corresponding emission wavelength band thereof. For example, if the corresponding emission wavelength of the light emitted by the light-emitting structure 20 of the flip-chip light-emitting diode 1 is 850 nm, the transparent ohmic contact layer 224 may be made of indium gallium phosphide (InGaP) material, which would not absorb the light of the wavelength of 850 nm. However, the material used for the transparent ohmic contact layer 224 is not limited thereto.

The P-type electrode structure 30 is disposed on the gallium phosphide layer 21 of the light-emitting structure 20. In one embodiment of the present invention, the P-type electrode structure 30 includes a finger electrode portion 31 and a pad portion 32. The finger electrode portion 31 is in contact with the gallium phosphide layer 21 of the light-emitting structure 20 and the pad portion 32 respectively. The finger electrode portion 31 is positioned in a periphery of the semiconductor epitaxy structure 22 and neither extends into an internal region of the semiconductor epitaxy structure 22 nor contacts with the semiconductor epitaxy structure 22. Furthermore, the finger electrode portion 31 is symmetrically arranged with respect to a center of the semiconductor epitaxy structure 22. The pad portion 32 connects the finger electrode portion 31 and serves as an electrical contact for connecting external components.

The N-type electrode structure 40 is disposed on the transparent ohmic contact layer 224. In one embodiment of the present invention, the N-type electrode structure 40 includes a current confinement layer 41 and a metal reflection layer 42, and the current confinement layer 41 and the metal reflection layer 42 are disposed in an interior of the semiconductor epitaxy structure 22. The current confinement layer 41 is disposed on the transparent ohmic contact layer 224, and the current confinement layer 41 has at least one opening 411. Depending on different designs, each opening 411 can be a circular hole, a linear hole, or any other types of openings. The current confinement layer 41 is made of a non-conductive material, such as silicon dioxide (SiO₂), silicon nitride (Si₃N₄), magnesium fluoride (MgF₂), or titanium dioxide (TiO₂), but the material adopted for the current confinement layer 41 is not limited to these examples.

The metal reflection layer 42 fully covers the current confinement layer 41 and coordinates in conjunction with the current confinement layer 41 to form an omni-directional reflector (ODR), providing a light reflection effect. After the metal reflection layer 42 is disposed, at least one ohmic contact structure 421 can be formed through the at least one opening 411, so that the metal reflection layer 42 contacts with the transparent ohmic contact layer 224. The at least one ohmic contact structure 421 serves as a current conduction path, ensuring an evenly distributing effect for the current between the metal reflection layer 42 and the transparent ohmic contact layer 224. When the at least one opening 411 are a plurality of circular holes, the at least one ohmic contact structure 421 there formed will be a plurality of dot ohmic contact structures, wherein the plurality of the dot ohmic contact structures are arranged uniformly. When the at least one opening 411 are a plurality of linear holes, the at least one ohmic contact structure 421 there formed will be a plurality of line ohmic contact structures. Moreover, the N-type electrode structure 40 further includes a pad part 43, which is connected to the metal reflection layer 42 and serves as an electrical contact for connecting external components.

In the electroluminescent emission state of the flip-chip light-emitting diode 1 of the present invention, the light-emitting layer 222 of the semiconductor epitaxy structure 22 emits light within the corresponding emission wavelength band, with the light being emitted toward the substrate 10. Some of the light emitted toward the N-type semiconductor layer 223 will be influenced by the distributed Bragg reflector

(DBR), and induced a light reflection effect, so that the light would not easily pass through the N-type semiconductor layer 223 to map an image of the N-type electrode structure 40, preventing a specific shadow region to occur. Furthermore, for the flip-chip light-emitting diode 1 of the present invention, by arranging the P-type current diffusing layer 221 of the semiconductor epitaxy structure 22 and in conjunction with the current confinement layer 41 and metal reflection layer 42 of the N-type electrode structure 40, the omni-directional reflector (ODR) is collectively formed, which not only ensures that the current spreads uniformly without concentrating in specific areas to maintain an even light-emitting effect, but also provides an additional light reflection effect for remaining light passing through the N-type semiconductor layer 223 to effectively solve shadow region problems in near-field optics.

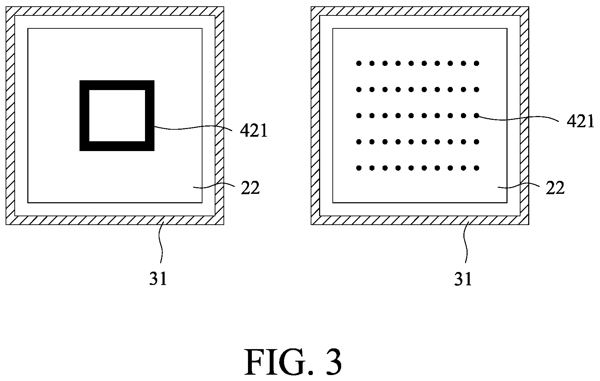

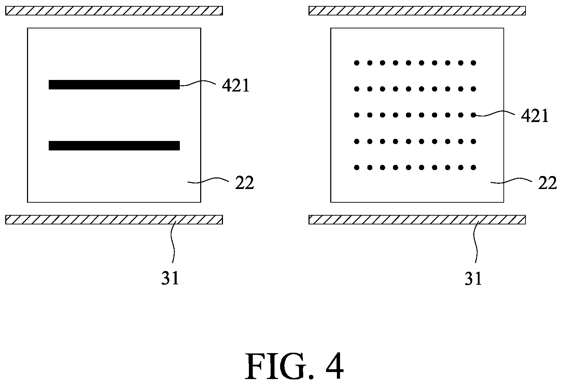

Please refer to FIG. 3 and FIG. 4. FIG. 3 is an exemplary layout view of the finger electrode portion of the P-type electrode structure and the at least one ohmic contact structure of the N-type electrode structure of the flip-chip light-emitting diode of the present invention. FIG. 4 is another exemplary layout view of the finger electrode portion of the P-type electrode structure and the at least one ohmic contact structure of the N-type electrode structure of the flip-chip light-emitting diode of the present invention. As shown in FIG. 3 and FIG. 4, in the circuit layout configuration, the finger electrode portion 31 of the P-type electrode structure 30 is related to at least one ohmic contact structure 421 of the metal reflection layer 42 of the N-type electrode structure 40, ensuring that the current distribution is not concentrated in any specific area.

As shown in FIG. 3, in one embodiment of the present invention, the finger electrode portion 31 of the P-type electrode structure 30 is designed as a single frame electrode, and the finger electrode portion 31 surrounds the semiconductor epitaxy structure 22. The at least one ohmic contact structure 421 of the corresponding N-type electrode structure 40 can cooperatively be a plurality of dot electrodes that are dispersed and regularly arranged. For example, the plurality of dot electrodes can be arranged in an equidistantly spaced way, along a plurality of straight lines parallel to any side of the frame electrode of the finger electrode portion 31 (as shown in a right side diagram of FIG. 3), or arranged as another frame electrode within a range of the frame electrode of the finger electrode portion 31 (as shown in a left side diagram of FIG. 3).

As shown in FIG. 4, in one embodiment of the present invention, the finger electrode portion 31 of the P-type electrode structure 30 is designed as a set of parallel line electrodes, with two line electrodes parallel with each other, wherein these two line electrodes are disposed near and parallel to two opposite sides of the semiconductor epitaxy structure 22 respectively. Cooperatively, the at least one ohmic contact structure 421 of the corresponding N-type electrode structure 40 can be a plurality of dot electrodes that are dispersed and regularly arranged. For example, the plurality dot electrodes can be arranged in an equidistantly spaced way, along a plurality of straight lines, parallel to any side of the frame electrode of the finger electrode portion 31 (as shown in a right side diagram of FIG. 4), or arranged as another set of parallel line electrodes disposed within the range of the frame electrode of the finger electrode portion 31 and parallel to the set of parallel line electrodes (as shown in a left side diagram of FIG. 4).

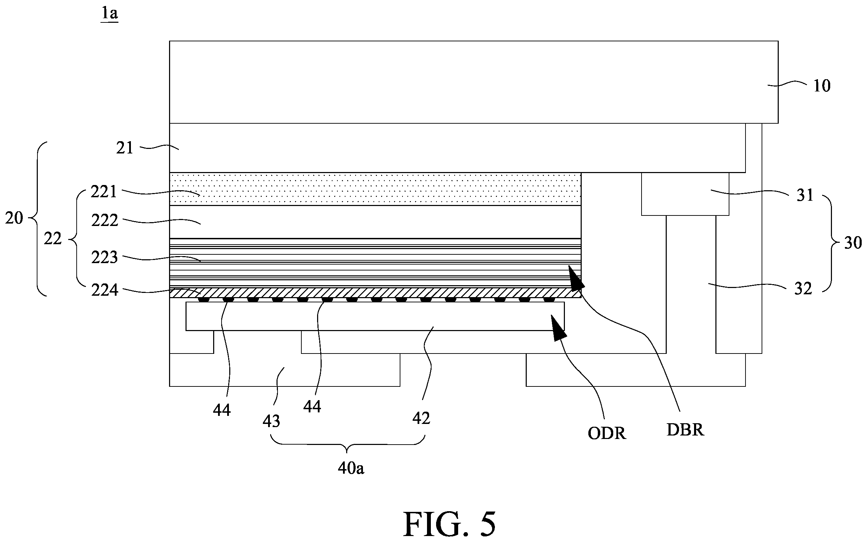

Please refer to FIG. 5, which is a schematic view of another embodiment of the flip-chip light-emitting diode of the present invention. As shown in FIG. 5, in one embodiment of the present invention, forming the previously mentioned current confinement layer is omitted for the N-type electrode structure 40a of the flip-chip light-emitting diode 1a. Instead, a plurality of dot ohmic contact structures 44, being non-light-absorbing, are dispersed on the transparent ohmic contact layer 224, and the metal reflection layer 42 is connected to the transparent ohmic contact layer 224 through the plurality of dot ohmic contact structures 44, so that ohmic contacts between the metal reflection layer 42 and the transparent ohmic contact layer 224 are formed via each of the dot ohmic contact structures 44, thus to create a structure similar to the previously mentioned ohmic contact structure. In this embodiment, the plurality of dot contact ohmic structures are made from non-light-absorbing materials, such as indium gallium phosphide (InGaP).

Through the design, the flip-chip light-emitting diode of the present invention increases a contact area between the P-type electrode and the P-type semiconductor layer by embedding the P-type electrode into the P-type semiconductor layer, so as to reduce a resistance of the P-type electrode. In terms of circuit design, a linewidth of the P-type electrode is narrowed, so that a light-emitting area is increased to enhance an overall brightness of the flip-chip light-emitting diode.

The above implementations are only auxiliary descriptions, and are not intended to limit the embodiments of the application subject or the applications or uses of the embodiments. In addition, although at least one illustrative example has been presented above, it should be understood that the present invention can still have a large quantity of variations. It should also be understood that the embodiments described herein are not intended to limit the scope, use, or configuration of the requested subject matter in any way. On the contrary, the foregoing embodiments will provide a convenient guide for those skilled in the art to implement one or more embodiments. Furthermore, various changes can be made to the function and arrangement of the components without departing from the scope defined by the patent claims, and the scope of the patent claims includes known equivalents and all foreseeable equivalents at the time that the patent application is filed.

## Claims

1. A flip-chip light-emitting diode, comprising:
a substrate;
a light-emitting structure, disposed on the substrate and including a gallium phosphide layer and a semiconductor epitaxy structure, wherein the gallium phosphide layer is positioned between the substrate and the semiconductor epitaxy structure, the semiconductor epitaxy structure has a P-type current diffusing layer, a light-emitting layer, an N-type semiconductor layer, and a transparent ohmic contact layer, the P-type current diffusing layer is disposed on the gallium phosphide layer, the light-emitting layer is disposed on the P-type current diffusing layer, the N-type semiconductor layer is disposed on the light-emitting layer, and the transparent ohmic contact layer is disposed on the N-type semiconductor layer;
a P-type electrode structure, disposed on the gallium phosphide layer of the light-emitting structure; and
an N-type electrode structure, disposed on the transparent ohmic contact layer;
wherein the N-type semiconductor layer has a distributed Bragg reflector, and the distributed Bragg reflector is located between the light-emitting layer and the N-type electrode structure.

2. The flip-chip light-emitting diode as claimed in claim 1, wherein the N-type electrode structure includes a current confinement layer and a metal reflection layer, the current confinement layer is disposed on the transparent ohmic contact layer and has a plurality of openings, and the metal reflection layer covers the current confinement layer to form an omni-directional reflector in conjunction with the current confinement layer; and wherein the metal reflection layer forms a plurality of dot ohmic contact structures with the transparent ohmic contact layer through the plurality of openings.

3. The flip-chip light-emitting diode as claimed in claim 2, wherein the current confinement layer is made of a non-conductive material.

4. The flip-chip light-emitting diode as claimed in any of the previous claims, wherein a resistance of the P-type current diffusing layer is lower than a resistance of the N-type semiconductor layer.

5. The flip-chip light-emitting diode as claimed in any of the previous claims, wherein the P-type current diffusing layer is an aluminum gallium arsenide layer with a doping concentration exceeding 1E+19 atoms/cm³.

6. The flip-chip light-emitting diode as claimed in any of the previous claims, wherein the transparent ohmic contact layer is made of a material that does not absorb light emitted by the light-emitting layer within a corresponding emission wavelength band thereof.

7. The flip-chip light-emitting diode as claimed in any of the previous claims, wherein the P-type electrode structure includes a finger electrode portion and a pad portion, the finger electrode portion respectively contacts with the gallium phosphide layer of the light-emitting structure and with the pad portion, and the finger electrode portion is positioned in a periphery of the semiconductor epitaxy structure and symmetrically arranged with respect to a center of the semiconductor epitaxy structure.

8. The flip-chip light-emitting diode as claimed in claim 7, wherein the finger electrode portion is a frame electrode, and the N-type electrode structure is either a plurality of regularly arranged dot electrodes or another frame electrode.

9. The flip-chip light-emitting diode as claimed in claim 7, wherein the finger electrode portion is a set of parallel line electrodes, and the N-type electrode structure is either a plurality of regularly arranged dot electrodes or another set of parallel line electrodes that are parallel to the finger electrode portion.

10. The flip-chip light-emitting diode as claimed in any of the previous claims, wherein the N-type electrode structure is a plurality of dot ohmic contact structures disposed on the transparent ohmic contact layer, and each of the dot ohmic contact structures forms an ohmic contact with the transparent ohmic contact layer.
